**Europäisches Patentamt**

**European Patent Office**

**Office européen des brevets**

(11) Veröffentlichungsnummer: **0 220 405**
A1

## (12) EUROPÄISCHE PATENTANMELDUNG

(21) Anmeldenummer: **86111247.2**

(22) Anmeldetag: **14.08.86**

(51) Int. Cl.⁴: **H 01 S 3/19**

(30) Priorität: **27.08.85 DE 3530466**

(43) Veröffentlichungstag der Anmeldung: **06.05.87**
**Patentblatt 87/19**

(84) Benannte Vertragsstaaten: **AT BE CH DE FR GB IT LI NL SE**

(71) Anmelder: **Licentia Patent-Verwaltungs-GmbH, Theodor-Stern-Kai 1, D-6000 Frankfurt/Main 70 (DE)**

(72) Erfinder: **Krumpholz, Oskar, Dr.-Ing., Amselweg 57, D-7900 Ulm (DE)**
Erfinder: **Marschall, Peter, Entw.-Ing., Krankenhausstrasse 1, D-7910 Neu-Ulm (DE)**

(74) Vertreter: **Schulze, Harald Rudolf, Dipl.-Ing. et al, Licentia Patent-Verwaltungs-GmbH Theodor-Stern-Kai 1, D-6000 Frankfurt/Main 70 (DE)**

(54) **Indexgeführter Halbleiterlaser.**

(57) Die Erfindung betrifft einen indexgeführten Halbleiterlaser insbesondere für die optische Nachrichtenübertragung über Lichtwellenleiter bei einem Lichtwellenlängenbereich von ungefähr 1,2 μm bis 1,6 μm. Die erforderliche Doppelheterostruktur wird in kostengünstiger und zuverlässiger Weise als stegförmige Struktur ausgebildet, deren Breite vorgebbar ist und z.B. kleiner als 3 μm beträgt. Dadurch ist ein elektrischer Schwellstrom von weniger als 30 mA erreichbar.

ACTORUM AG

Licentia Patent-Verwaltungs-GmbH          PTL-UL/Ja/rß
Theodor-Stern-Kai 1                       UL 85/92
D-6000 Frankfurt 70
                                          Aktz .:
                                          P 35 30 466.9


**Beschreibung**


"Indexgeführter Halbleiterlaser"

Die Erfindung betrifft einen indexgeführten Halbleiterlaser
nach dem Oberbegriff des Patentanspruchs 1.

Halbleiterlaser werden als indexgeführt bezeichnet, wenn die
seitlich an die laseraktive Zone angrenzenden Schichten einen
niedrigeren optischen Brechungsindex besitzen, so daß in
der laseraktiven Zone erzeugtes Licht in dieser geführt
wird.

Bei der optischen Nachrichtenübertragung über Quarzglas-
Lichtwellenleiter ist es zweckmäßig, für das zu übertragende Licht eine Wellenlänge von z.B. 1,5 µm im nahen
Infrarotbereich zu wählen, da die Lichtwellenleiter in
diesem Spektralbereich eine sehr niedrige Dämpfung von

...

z.B. 0.1dB/km besitzen. Als optische Sendeelemente sind Halbleiterlaser geeignet, die aus dem Halbleitermaterial Indium-Gallium-Arsen-Phosphid (InGaAsP)/Indiumphosphid (InP) bestehen. Aus diesem Halbleitermaterial hergestellte Halbleiterlaser haben jedoch den Nachteil, daß deren optische und/oder elektrische Eigenschaften in störender Weise eine große Temperaturabhängigkeit besitzen. Zur Vermeidung einer unwirtschaftlichen aktiven Anordnung zur Temperaturstabilisierung ist es daher erforderlich, den Halbleiterlaser so zu gestalten, daß ein möglichst geringer elektrischer Schwellstrom (Einsatzpunkt der Laserstrahlung) von z.B. kleiner 50mA erforderlich ist. Derartig niedrige Schwellströme sind lediglich mit indexgeführten Laserstrukturen erreichbar.

Die Herstellung indexgeführter Halbleiterlaser vom sogenannten BH-Typ ("burried heterostructure"),mit denen die niedrigsten Schwellströme erreichbar sind, erfordert im allgemeinen. z.B. bei dem sogenannten DC-PBH-Halbleiterlaser. eine sehr komplizierte Halbleiter-Vielschichtstruktur zur Einengung des elektrischen Stromflusses auf die laseraktive Zone. Eine derartige Struktur ist insbesondere bei einer industriellen Massenfertigung lediglich in kostenungünstiger Weise herstellbar.

Der Erfindung liegt daher die Aufgabe zugrunde, einen gattungsgemäßen Halbleiterlaser anzugeben, der einen möglichst einfachen sowie kostengünstig und zuverlässig herstellbaren Aufbau besitzt.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Ein Vorteil der Erfindung besteht darin, daß die Breite der laseraktiven Zone in kostengünstiger und zuverlässiger Weise einstellbar ist, z.B. auf eine Breite von ungefähr 2µm. so daß eine optisch verlustarme Ankopplung des Halbleiterlasers an einen Monomodelichtwellenleiter möglich ist. der einen lichtführenden Kern mit einem Durchmesser von ungefähr 9 µm besitzt.

Die Erfindung wird im folgenden anhand von Ausführungsbeispielen unter Bezugnahme auf eine schematische Zeichnung näher erläutert. Es zeigen:

FIG: 1 und 2    schematische Darstellungen zur Erläuterung des Herstellungsvorganges des Halbleiterlasers

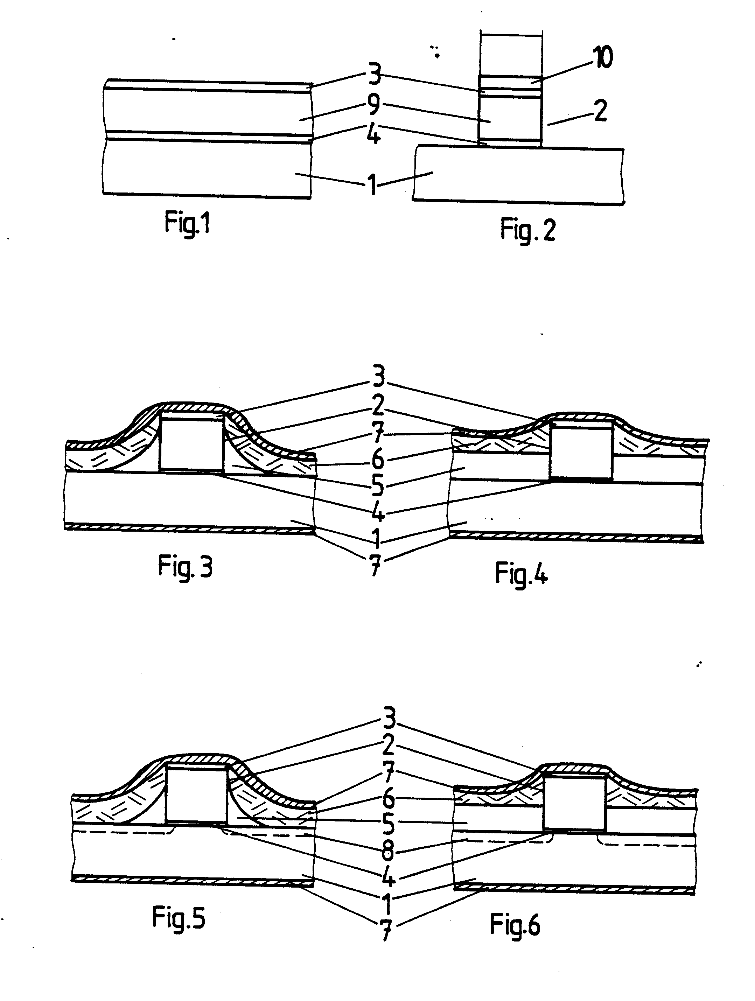

FIG. 3 bis 6    Ausführungsbeispiele des vollständigen Halbleiterlasers.

Fig. 1 zeigt ein Substrat 1, z.B. aus n-InP mit einer Ladungsträgerkonzentration von ungefähr $5 \cdot 10^{17}/cm^3$ bis $10^{18}/cm^3$ sowie einer Dicke von ungefähr 100 µm . Auf das Substrat 1 wird z.B. durch Epitaxievorgänge nacheinander die folgende Halbleiterschichtenfolge aufgewachsen, so daß eine sogenannte Doppelheterostruktur entsteht:

laseraktive Zone 4. bestehend aus undotiertem InGaAsP mit einer Dicke von ungefähr 0,1µm bis 0,2µm

Mantelschicht 9 aus p-InP mit einer Ladungsträgerkonzentration von ungefähr $5 \cdot 10^{17}/cm^3$ und einer Dicke von ungefähr 1,5 µm bis 2µm

Kontaktierungsschicht 3 aus p-InGaAsP mit einer Ladungsträgerkonzentration von größer als $10^{18}/cm^3$ und einer Dicke von ungefähr 0,5µm.

Auf diese quarternäre Kontaktierungsschicht 3 wird nun ganzflächig eine Schicht, z.B. aus Photolack, aufgebracht, aus der im wesentlichen parallel nebeneinander liegende streifenförmige Ätzmasken 10 herstellbar sind mit einer Breite b. welche der gewünschten Breite, z.B. 2µm, der laserkaktiven Zone des vollständigen Halbleiterlasers entspricht. Nicht durch die Ätzmaske 10 geschütztes Halbleitermaterial wird nun bis zum Substrat 1 weggeätzt, welches die andere optische Mantelschicht bildet. Es entsteht ein Steg 2 mit Doppelheterostruktur-Halbleiterschichtenfolge (Fig. 2). Es entsteht ein strukturierter Halbleiterkörper, der nach dem Entfernen der Ätzmaske 10 zu verschiedenen Ausführungsbeispielen weiterverarbeitbar ist.

In den Ausführungsbeispielen gemäß Fig. 3 und 4 wird zumindest seitlich der laseraktiven Zone 4 eine Sperrschicht 5 aufgewachsen. Diese bewirkt einen mechanischen Halt für den Steg 2, ein Einengen des elektrischen Stromflusses auf den Steg 2 und die erforderliche seitliche optische Wellenführung des Lichts.

Für die Sperrschicht 5 sind daher verschiedene Materialien geeignet, z.B. eigenleitendes hochohmiges n- oder p-InP mit einer Ladungsträgerkonzentration von kleiner $10^{16}$/cm³ oder eine Halbleiterschichtenfolge, die als sperrender PN-Übergang wirkt oder Halbleitermaterial, z.B. InP, daß einen höheren Bandabstand besitzt als die quarternäre laseraktive Zone 4. Gemäß Fig. 3 befindet sich die Sperrschicht 5 lediglich in benachbarten Bereichen der laseraktiven Zone 4, in den übrigen Bereichen liegt das Substrat 1 frei. Auf die Sperrschicht 5 sowie das möglicherweise freiliegende Substrat wird nun eine Isolierschicht 6 aufgebracht, die lediglich die Kontaktierungsschicht 3 freiläßt. Diese Isolierschicht 6 besteht z.B. aus Siliziumdioxid und/oder Polyimid und hat eine beispielhafte Dicke von ungefähr 1,5 µm. Auf die Kontaktierungsschicht 3, die Isolierschicht 6 sowie auf die Unterseite des Substrates 1 wird nun ganzflächig eine in der Halbleitertechnologie derzeit übliche Metall-Kontaktschicht 7 aufgebracht, z.B. mit einer Dicke von ungefähr 0,5 µm. Diese Kontaktschicht 7 besteht z.B. aus einer Ti-Pt -Au-Schichtenfolge.

Der beschriebene Aufbau wird nun in derzeit üblicher Weise zerteilt und bearbeitet, daß Halbleiterlaser entstehen. deren Steg 2 eine Länge von ungefähr 250 µm besitzt.

Die Ausführungsbeispiele gemäß Fig. 5 und Fig. 6 unterscheiden sich von den bisher beschriebenen lediglich dadurch. daß vor dem Aufwachsen der Sperrschicht 5 in dem Substrat 1 eine zusätzliche Diffusionsschicht 8 erzeugt wird. Diese besteht z.B.aus p-InP mit einer Dicke von ungefähr 0.4 µm und einer Ladungsträgerkonzentration von ungefähr 2 · $10^{17}$/cm³. Durch diese Diffusionsschicht 8 wird in dem vollständigen Halbleiterlaser ein sperrender pn-Übergang erzeugt, welcher den elektrischen Stromfluß in erwünschter Weise auf den Steg 2 und damit die laseraktive Zone 4 einengt.

Die Erfindung ist nicht auf die beschriebenen Ausführungsbeispiele beschränkt, sondern sinngemäß auf weitere anwendbar. Beispielsweise ist es möglich, auf dem Halbleitermaterial GaAs (Substrat) aufgebaute Halbleiterlaser sinngemäß zu strukturieren. Derartige Halbleiterlaser sind für Lichtwellenlängen von ungefähr 0,8µm geeignet.

0220405

Licentia Patent-Verwaltungs-GmbH
Theodor-Stern-Kai 1

D-6000 Frankfurt 70

PTL-UL/Ja/rß
UL 85/92

Aktz.:
P 35 30 466.9

## Patentansprüche

1. Indexgeführter Halbleiterlaser mit einer Halbleiterschichtenfolge, die eine laseraktive Zone als Bestandteil einer Doppelheterostruktur enthält, dadurch gekennzeichnet,

- daß auf einem kontaktierten Substrat (1) mindestens ein aus der Doppelheterostruktur-Halbleiterschichtenfolge mit darauf befindlicher Halbleiter-Kontaktierungsschicht (3) hergestellter Steg (2) vorhanden ist, der senkrecht zur Lichtausbreitungsrichtung eine vorgebbare Breite (6) besitzt,

- daß der Steg (2) zumindest im Bereich der laseraktiven Zone (4) seitlich durch eine Sperrschicht (5) begrenzt ist, durch die ein Stromfluß im wesentlichen auf den Bereich des Steges (2) eingeengt wird und die einen kleineren Brechungsindex als die laseraktive Zone (4) besitzt,

- daß die Sperrschicht 5 durch eine Isolationsschicht (6) abgedeckt ist und

...

- daß auf die Isolationsschicht (6) sowie die Halbleiter-Kontaktierungsschicht (3) eine Metall-Kontaktschicht (7) aufgebracht ist.

2. Halbleiterlaser nach Anspruch 1, dadurch gekennzeichnet, daß die Sperrschicht (5) aus einem derart hochohmigen
Halbleitermaterial besteht, daß der Stromfluß auf den Steg
(2) begrenzt wird.

3. Halbleiterlaser nach Anspruch 1, dadurch gekennzeichnet, daß die Sperrschicht (5) aus einem Halbleitermaterial
besteht, daß einen größeren Bandabstand besitzt als das
Halbleitermaterial der laseraktiven Zone (4).

4. Halbleiterlaser nach einem der vorhergehenden Ansprüche, dadurch gekennzeichnet, daß die Breite (b) des
Steges (2) nach Maßgabe der Anwendungsart des Halbleiterlasers gewählt ist.

5. Halbleiterlaser nach einem der vorhergehenden Ansprüche, dadurch gekennzeichnet, daß in dem Substrat (1)
eine Diffusionsschicht (8) vorhanden ist, welche den
Stromfluß auf den Steg (2) begrenzt.

6. Halbleiterlaser nach einem der vorhergehenden Ansprüche, dadurch gekennzeichnet, daß die Isolationsschicht
als Oxidschicht und/oder Polyimidschicht ausgebildet ist.

7. Halbleiterlaser nach einem der vorhergehenden Ansprüche, dadurch gekennzeichnet, daß die laseraktive Zone
(4) aus Indium-Gallium-Arsen-Phosphid besteht und durch
Indiumphosphid-Schichten eingegrenzt ist.

...

8. Halbleiterlaser nach einem der vorhergehenden Ansprüche, dadurch gekennzeichnet, daß die Kontaktierungsschicht (3) als quarternäre InGaAsP-Schicht ausgebildet ist.

9. Halbleiterlaser nach einem der vorhergehenden Ansprüche, dadurch gekennzeichnet, daß die an die laseraktive Zone (4) substratseitig angrenzende Schicht als optische Mantelschicht ausgebildet ist.

0220405

Fig.1    Fig.2

Fig.3    Fig.4

Fig.5    Fig.6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-A-2 747 371 (HITACHI LTD.) * Seite 11, Zeile 1 - Seite 12, Zeile 28; Seite 17, Zeile 1 - Seite 18, Zeile 30; Abbildung 2 * | 1-3 | H 01 S 3/19 |
| | --- | | |
| X | XEROX DISCLOSURE JOURNAL, Band 4, Nr. 3, Mai/Juni 1979, Seiten 353-354, Connecticut, US; R.D. BURNHAM et al.: "Buried single heterostructure lasers" * Insgesamt * | 1-3,5, 6 | |
| | --- | | |
| A | US-A-4 213 805 (T. TSUKADA) * Spalte 1, Zeilen 30-50; Spalte 2, Zeilen 26-68; Abbildungen 1,3 * & DE-A-2 507 357 | 1-3 | |
| | --- | | RECHERCHIERTE SACHGEBIETE (Int. Cl.4) |
| A | IEEE JOURNAL OF QUANTUM ELECTRONICS, Band QE-13, Nr. 8, August 1977, Seiten 623-627, New York, US; K. ITOH et al.: "Embedded-stripe GaAs-GaAIAs double-heterostructure lasers with polycrystalline GaAsP layers-I: Lasers with cleaved mirrors" * Abschnitte I,II * | 1,2 | H 01 S |
| | --- -/- | | |

Der vorliegende Recherchenbericht wurde für alle Patentansprüche erstellt.

| Recherchenort | Abschlußdatum der Recherche | Prüfer |
|---|---|---|
| DEN HAAG | 05-12-1986 | HORAK G.I. |